(19) Europäisches Patentamt
European Patent Office
Office européen des brevets

(11) **EP 4 597 849 A1**

(12) **EUROPEAN PATENT APPLICATION**
published in accordance with Art. 153(4) EPC

(43) Date of publication:
**06.08.2025   Bulletin 2025/32**

(21) Application number: **23891449.3**

(22) Date of filing: **09.11.2023**

(51) International Patent Classification (IPC):
*H03M 13/29* (2006.01)     *H03M 13/27* (2006.01)
*H04L 1/00* (2006.01)

(52) Cooperative Patent Classification (CPC):
**H03M 13/27; H03M 13/29; H04L 1/00**

(86) International application number:
**PCT/JP2023/040327**

(87) International publication number:
**WO 2024/106297 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:   **15.11.2022   JP 2022182371**

(71) Applicant: **Sigcode, Inc.
Tokyo 155-0031 (JP)**

(72) Inventors:
• **BOHULU, Kwame Ackah
  Tokyo 192-0904 (JP)**
• **HAN, Chenggao
  Tokyo 155-0031 (JP)**

(74) Representative: **Hoffmann Eitle
Patent- und Rechtsanwälte PartmbB
Arabellastraße 30
81925 München (DE)**

(54) **TURBO CODE DESIGN METHOD, TURBO CODE DESIGN DEVICE, AND RECORDING MEDIUM STORING TURBO CODE DESIGN PROGRAM**

(57)   A turbo code designing method for designing a turbo encoding using a high-performance interleaver is provided. A turbo encoder is provided with a first convolutional encoder, an interleaver, and a second convolutional encoder. The first convolutional encoder generates a first parity stream of input data by use of a predetermined RSC encoding. The interleaver swaps an order of series inside the input data based on a first rule to generate a swapped data. The second convolutional encoder generates a second parity stream of the swapped data by use of the RSC encoder. The turbo code designing method includes selecting a polynomial that indicate the RSC encoding from a Galois field of polynomials and designing the first rule of the interleaver based on the RSC encoding.

FIG. 3

```
        ┌─────────┐
        │  Start  │
        └─────────┘
             │
  ┌────────────────────────┐  S01
  │ Selecting RSC Encoding │
  └────────────────────────┘
             │
  ┌────────────────────────┐  S02
  │      Designing PM      │
  └────────────────────────┘
             │
  ┌────────────────────────┐  S03
  │    Designing Coset     │
  └────────────────────────┘
             │
  ┌────────────────────────┐  S04
  │ Outputting Turbo Encoding │
  └────────────────────────┘
             │
        ┌─────────┐
        │   End   │
        └─────────┘
```

EP 4 597 849 A1

**Description**

TECHNICAL FIELD

The present invention relates to a turbo code designing method, a turbo code designing apparatus, and a recording medium stored with a turbo code designing program.

BACKGROUND

A turbo encoding is known as an error correcting encoding having a performance relatively closed to a so-called Shannon limit. In the turbo encoding, output data is generated by combining input data, a parity stream of the input data, and a parity stream of a swapped data in which an order of series inside the input data is swapped.

A circuit that swaps the order of the series inside the input data is called an interleaver. As an interleaver, a semi-random (S-Random) interleaver and a quadratic permutation polynomial (QPP) interleaver are known. However, in case of the S-Random interleaver, there is a problem in that a size of memory required for encoding and/or decoding is relatively large, and that parallel decoding processing is not possible. In addition, in case of the QPP interleaver, there is a problem in that a performance is worse than the S-Random interleaver when a bit length is relatively long (for example, 1024 bits).

In connection with the above, non-patent literature 1 ("LTE Envolved Universal Terrestrial Radio Access (E-UTRA): Multiplexing and Channel Coding", Third Generation Partnership Project (3GPP (registered trademark)) Std., January 2011) discloses that a turbo encoding using the QPP interleaver is adopted in Long-Term Evolution (LTE).

Cited document

Non-Patent Literature

Non-Patent Literature 1: "LTE Envolved Universal Terrestrial Radio Access (E-UTRA): Multiplexing and Channel Coding", Third Generation Partnership Project (3GPP) Std., January 2011.

SUMMARY

In view of the above circumstances, an objective of the present disclosure is to provide a turbo code designing method, a turbo code designing apparatus, and a recording medium stored with a turbo code designing program for designing a turbo encoding that uses a high-performance interleaver. Other objectives and novel features will be apparent from the description of the present specification and accompanying drawings.

According to an embodiment, a turbo code designing method is a turbo code designing method that designs a turbo encoding. A turbo encoder that executes a turbo encoding is provided with a first convolutional encoder, an interleaver, and a second convolutional encoder. The first convolutional encoder generates a parity stream of input data as a first parity stream by use of a predetermined recursive systematic convolutional (RSC) encoding. The interleaver swaps an order of series inside the input data based on a first rule to generate swapped data. The second convolutional encoder generates a parity stream of the swapped data as a second parity stream by use of the RSC encoding. The turbo code designing method includes selecting a polynomial that indicates the RSC encoding among elements of a Galois field generated by a generator polynomial, designing the first rule of the interleaver based on the RSC encoding, and outputting information that indicates the designed turbo encoding outside. The polynomial that indicates the RSC encoding includes a feedforward polynomial that indicates a feedforward connection and a feedback polynomial that indicates a feedback connection. Each of the feedforward polynomial and the feedback polynomial is a polynomial selected among the elements of the Galois field or a multiplied product of a plurality of polynomials selected among the elements of the Galois field.

According to an embodiment, a turbo code designing apparatus is a turbo code designing apparatus that designs a turbo encoding. A turbo encoder that executes a turbo encoding is provided with a first convolutional encoder, an interleaver, and a second convolutional encoder. The first convolutional encoder generates a parity stream of input data as a first parity stream by use of a predetermined recursive systematic convolutional (RSC) encoding. The interleaver swaps an order of series inside the input data based on a first rule to generate swapped data. The second convolutional encoder generates a parity stream of the swapped data as a second parity stream by use of the RSC encoding. The turbo code designing apparatus is provided with an RSC code selecting section, a PM designing section, a coset designing section, and an outputting section. The RSC code selecting section selects a polynomial that indicates the RSC encoding among the Galois field of polynomials. The PM designing section designs a permutation matrix (PM) that indicates a correspondence of an order of inside series between the input data and the swapped data, based on a period of the RSC encoding. The coset designing section designs a second rule for generating a plurality of sets that are prime to each other as a plurality of cosets by splitting the input data, based on the period of the RSC encoding. The outputting section outputs information that indicates the designed turbo encoding outside. The polynomial that indicates the RSC encoding is a polynomial selected from the Galois field or a multiplied product of a plurality of polynomials selected from the Galois field. The period of the RSC encoding is a circulation period bit length when a predetermined bit and subsequent bits thereafter of an output data of the RSC encoding inputted with input data of which a first bit is 1 and a second bit and subsequent bits thereafter are 0 circulate at a predetermined period.

According to an embodiment, a recording medium stored with a turbo code designing program stores a program that realizes a process for designing a turbo encoding by making a processor execute. A turbo encoder that executes a turbo encoding is provided with a first convolutional encoder, an interleaver, and a second convolutional encoder. The first convolutional encoder generates a parity stream of input data as a first parity stream by use of a predetermined recursive systematic convolutional (RSC) encoding. The interleaver swaps an order of series inside the input data based on a first rule to generate swapped data. The second convolutional encoder generates a parity stream of the swapped data as a second parity stream by use of the RSC encoding. The process for designing the turbo encoding includes selecting a polynomial that indicates the RSC encoding among elements of a Galois field generated by a generator polynomial, designing the first rule of the interleaver based on the RSC encoding, and outputting information that indicates the designed turbo encoding outside. The polynomial that indicates the RSC encoding includes a feedforward polynomial that indicates a feedforward connection and a feedback polynomial that indicates a feedback connection. Each of the feedforward polynomial and the feedback polynomial is a polynomial selected among the elements of the Galois field or a multiplied product of a plurality of polynomials selected among the elements of the Galois field.

According to an embodiment, a turbo encoding using a high-performance interleaver can be designed.

BRIEF DESCRIPTION OF THE DRAWINGS

[FIG. 1A] FIG. 1A is a block circuit diagram that shows a configuration example of a turbo encoder according to an embodiment.
[FIG. 1B] FIG. 1B is a block circuit diagram that shows a configuration example of a convolutional encoder according to an embodiment.
[FIG. 2] FIG. 2 is a block circuit diagram that shows a configuration example of a turbo code designing apparatus according to an embodiment.
[FIG. 3] FIG. 3 is a flowchart that shows a configuration example of a process of a turbo code designing method according to an embodiment.
[FIG. 4] FIG. 4 is a table that shows an example of root orders and periods of RSC encoding that respectively correspond to a plurality of polynomials.
[FIG. 5] FIG. 5 is a table that shows an example of correspondence between a generator polynomial of an RSC encoder and each power expression of Galois field elements generated by the generator polynomial.
[FIG. 6] FIG. 6 is a table that shows an example, when $(37/21)_8$ is selected as RSC encoding, of combination of hamming weight of a codeword, a common polynomial, an input bit sequence as swapped data, and an output bit sequence as a parity stream.
[FIG. 7] FIG. 7 is a table that shows an example of combination of parameters used in a general equation that indicates a swapped bit sequence when a hamming weight of an input bit sequence is 4.
[FIG. 8] FIG. 8 is a graph that shows an example of result of a computer simulation executed to verify validity of an RSC encoding according to an embodiment.
[FIG. 9] FIG. 9 is a graph that shows an example of result of a computer simulation of performance of a turbo encoding designed by a turbo code designing method according to an embodiment.
[FIG. 10] FIG. 10 is a graph that shows an example of result of a computer simulation of performance of a turbo encoding designed by a turbo code designing method according to an embodiment.
[FIG. 11] FIG. 11 is a graph that shows an example of result of a computer simulation of performance of a turbo encoding designed by a turbo code designing method according to an embodiment.
[FIG. 12] FIG. 12 is a graph that shows an example of result of a computer simulation of performance of a turbo encoding designed by a turbo code designing method according to an embodiment.
[FIG. 13] FIG. 13 is a block circuit diagram that shows a configuration example of a turbo encoder according to an embodiment.

DETAILED DESCRIPTION

An embodiment of a turbo code designing method, a turbo code designing apparatus, and a recording medium stored with a turbo code designing program according to the present disclosure will be described below with reference to attached drawings.

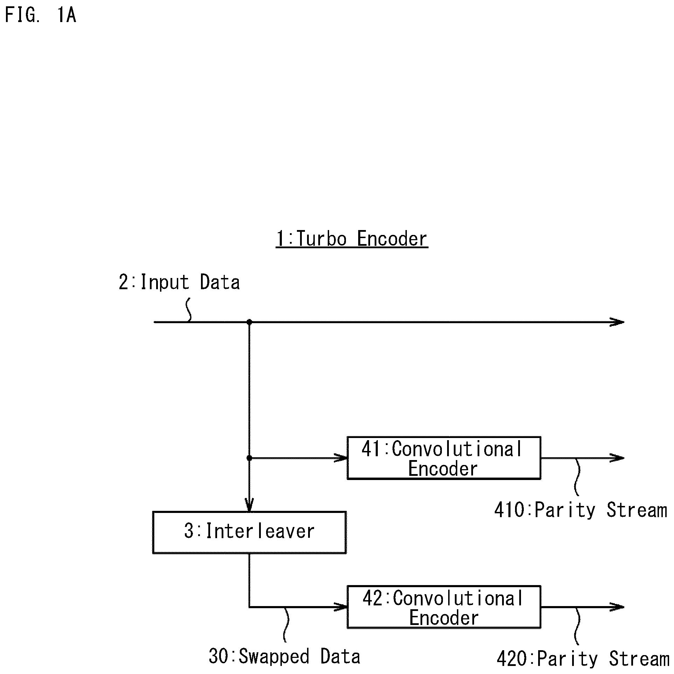

(Embodiment) As shown in FIG. 1A, a turbo encoder 1 that executes a turbo encoding is provided with an interleaver 3, a first convolutional encoder 41, and a second convolutional encoder 42. The turbo encoder 1 may be further provided with a coupler that is not illustrated.

The first convolutional encoder 41 applies a recursive systematic convolutional (RSC) encoding process to input data 2 to generate a parity stream 410 of the input data 2. The interleaver 3 executes a process of swapping an order of series inside the input data 2 based on a predetermined rule to generate swapped data 30. The second convolutional encoder 42 applies a process of RSC encoding to the swapped data 30 to generate a parity stream 420 of the swapped data 30.

The coupler that is not illustrated generates, based on the input data 2, the parity stream 410 of the input data 2, and the parity stream 420 of the swapped data 30, output data that is turbo-encoded input data 2. The coupler may generate intermediate data by partially decimating and multiplexing the parity streams 410, 420, and generate the output data by multiplexing the intermediate data and the input data 2.

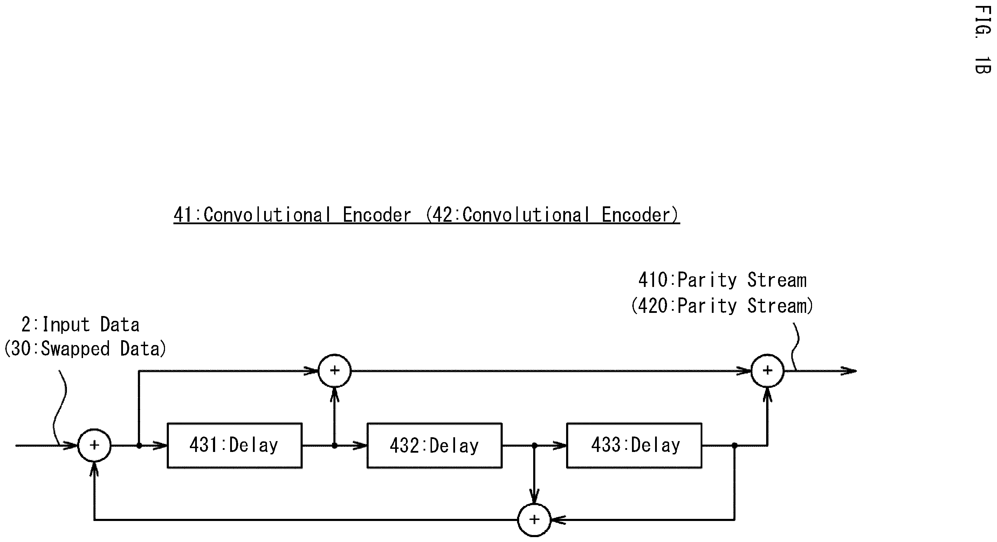

As shown in FIG. 1B, the convolutional encoders 41, 42 are provided with delays 431, 432, 433 and adders. The delays 431, 432, 433 are connected in series. A part of the adders adds an output of any one of the delays 431, 432, 433 to the input data 2 or the swapped data 30. In addition, another part of adders generates the parity stream 410 or 420 by adding the input data 2 or the swapped data 30 and an output of any one of the delays 431, 432, 433. The convolutional encoders 41, 42 are configured so as to correspond to the RSC encoding process that the convolutional encoders 41, 42 apply. In more detail, a total number of the delays 431, 432, 433, a total number of the adders, and connection relationship between the delays 431, 432, 433 and the adders are determined so as to correspond to a polynomial that indicates the RSC encoding that the convolutional encoders 41, 42 realize. The configuration of the convolutional encoders 41, 42 is the same. The delays 431, 432, 433 may be shift registers.

Designing the turbo encoding that the turbo encoder 1 executes includes designing the convolutional encoders 41, 42 and designing the interleaver 3. Designing the convolutional encoders 41, 42 includes selecting a polynomial that indicates the RSC encoding among elements of a Galois field generated by a generator polynomial. Herein, the polynomial that indicates the RSC encoding includes a feedforward polynomial that indicates a feedforward connection and a feedback polynomial that indicates a feedback connection. Each of the feedforward polynomial and the feedback polynomial is a polynomial selected among the elements of the Galois field or a multiplied product of a plurality of polynomials selected among the elements of the Galois field. Designing the interleaver 3 includes designing a permutation matrix (PM) based on the RSC encoding that the selected polynomial indicates and designing a coset based on the designed PM. Details of the PM and the coset will be described later.

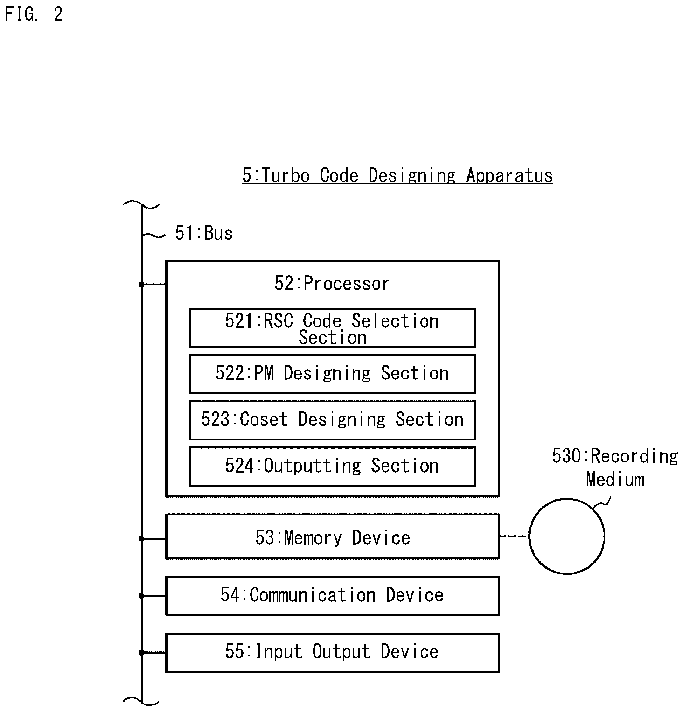

The designing of the turbo encoding may be performed by a turbo code designing apparatus 5 as shown in FIG. 2. A turbo code designing apparatus 5 according to an embodiment may be configured as a computer. The turbo code designing apparatus 5 is provided with a bus 51, a processor 52, a memory device 53, a communication device 54, and an input output device 55. The bus 51 is configured to connect the processor 52, the memory device 53, the communication device 54, and the input output device 55 to make communicable with each other.

The processor 52 is provided with an RSC code selecting section 521, a PM designing section 522, a coset designing section 523, and an outputting section 524. The memory device 53 readably stores the turbo code designing program. The turbo code designing program may be read out from the recording medium 530 stored with the turbo code designing program and then stored into the memory device 53. The processor 52 and the memory device 53 collaborate to realize a process of the turbo code designing program. In more detail, the processor 52 reads out the turbo code designing program and executes the turbo code designing program by using a memory area of the memory device 53 to execute processes of the RSC code selecting section 521, the PM designing section 522, the coset designing section 523, and the outputting section 524. The RSC code selecting section 521, the PM designing section 522, the coset designing section 523, and the outputting section 524 are virtual functional blocks that realize processes of the turbo code designing apparatus 5.

The RSC code selecting section 521 selects an RSC encoding at a step S01 that will be described later. The PM designing section 522 designs a PM at a step S02 that will be described later. The coset designing section 523 designs a coset at a step S03 that will be described later. The outputting section 524 outputs information that indicates the designed turbo encoding outside at a step S04 that will be described later. More specific actions of those functional blocks will be described later.

The communication device 54 performs transmissions and receptions of information to or from outside through a network that is not illustrated. As an example, the outputting section 524 controls the communication device 54 to output information outside. The turbo code designing program may be received by the communication device 54 from outside through the network and then stored into the memory device 53.

The input output device 55 outputs information to users and accepts operations the users input. As an example, the input output device 55 includes a display device that outputs images, a keyboard and/or a mouse that accept inputs, and the like.

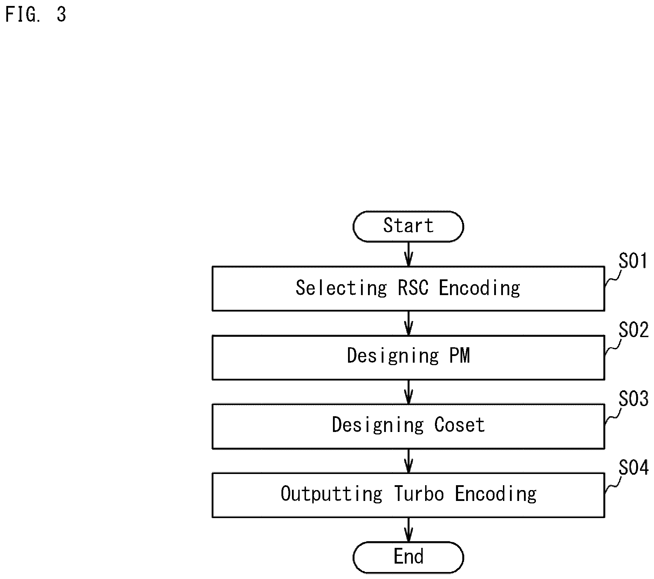

A process of the turbo code designing method according to an embodiment will be described with reference to the flowchart in FIG. 3. The process of the flowchart in FIG. 3 may start when the turbo code designing apparatus 5 starts, for example.

When the process of the flowchart in FIG. 3 starts, the step S01 is executed. In the step S01, the RSC code selecting section 521 in FIG. 2 selects an RSC encoding. In more detail, the RSC code selecting section 521 selects a polynomial that indicate the RSC encoding among elements of a Galois field of polynomials. In the polynomials as elements included in this Galois field, coefficient of each term is 0 or 1.

As shown in the example of FIG. 1B, in the convolutional encoders 41, 42 that execute RSC encoding, some of adders connect as feedforward an output of a part of the delays 431, 432, 433 to an output of the convolutional encoders 41, 42. The configuration of this feedforward connection is indicated as a polynomial f(x). In the example in FIG. 1B, the input of the convolutional encoders 41, 42, the output of a first stage delay 431, and the output of the third stage delay 433 are connected as feedback to the output of the convolutional encoder 41. Herein, the input of the convolutional encoders 41, 42 is an output of a virtual $0^{th}$ stage delay. The polynomial f(x) that indicates this configuration is equal to $x^0+x^1+x^3$, and the configuration of this feedforward connection is indicated as a polynomial $f(x)= 1+x+x^3$.

Similarly, in the convolutional encoders 41, 42 that execute the RSC encoding in FIG. 1B, some of the adders connect as feedback the output of a part of the delays 431, 432, 433 to the input of the convolutional encoders 41, 42. The configuration of this feedback connection is indicated as a polynomial g(x). In the example in FIG. 1B, the output of the second stage delay 432 and the output of the third stage delay 433 are connected as feedback to the input of the convolutional encoder 41. The polynomial g(x) that indicates this configuration is equal to $x^2+x^3$, and the configuration of this feedback connection is indicated as the polynomial $g(x)=x^2+x^3$. At that time, the generator function G of the RSC encoding is indicated as following "Math 1" equation.

[Math 1]

$$G = \begin{bmatrix} 1 & \dfrac{f(x)}{g(x)} \end{bmatrix}$$

Herein, "G" is a matrix with 1 row and 2 columns that indicates the generator function of the RSC encoding. "f(x)" is the polynomial that indicates the configuration of the feedforward connection. "g(x)" is the polynomial that indicates the configuration of the feedback connection.

An input bit sequence that is inputted by the feedback connection into the input of the convolutional encoders 41, 42 is indicated as a polynomial b(x). In addition, an output bit sequence that is outputted by the feedforward connection from the output of the convolutional encoders 41, 42 is indicated as a polynomial h(x). At that time, an output c(x) of the RSC encoding is indicated as following "Math 2" equation.

[Math 2]

$$c(x) = b(x^2) + xh(x^2)$$

In addition, the output bit sequence h(x) is indicated as following "Math 3" equation.

[Math 3]

$$h(x) = f(x)g^{-1}(x)b(x)$$

From the above "Math 2" equation, a hamming weight $w_H(c(x))$ of the output $c(x)$ of the RSC encoding is calculated as following "Math 4" equation, based on a hamming weight $w_H(b(x))$ of the input bit sequence $b(x)$ and a hamming weight $w_H(h(x))$ of the output bit sequence $h(x)$.

[Math 4]

$$w_H\big(c(x)\big) = w_H\big(b(x)\big) + w_H\big(h(x)\big)$$

A hamming weight of a polynomial is a sum of terms, among the terms included in this polynomial, of which the coefficient is not 0. In an embodiment, in order to make the design of the interleaver 3 of the turbo encoding easier, the polynomial $g(x)$ that indicates the configuration of the feedback connection is selected so that the hamming weight of the parity stream 420 (or the parity stream 410) that the convolutional encoder 42 (or the convolutional encoder 41) outputs becomes smaller than a predetermined first threshold value only when the swapped data 30 (or the input data 2) that is inputted into the convolutional encoder 42 (or the convolutional encoder 41) satisfies a predetermined condition. This first threshold value may be a free distance that is desired to be achieved by the turbo encoding for example, and a value of this free distance may be 42 for example. Alternatively, the first threshold value may be a value calculated based on the free distance that is desired to be achieved. As an example, a value obtained by dividing a difference, that is the free distance desired to be achieved subtracted with the hamming weight of the input bit sequence $b(x)$ and a minimal hamming weight of the output bit sequence $h(x)$, by a weight, 3 for example, in a period determined by the selected polynomial $f(x)$, may be set as the first threshold value. In addition, this condition is satisfied when the swapped data 30 (or the inputted data 2) is a value in which, in a binary notation thereof, a distance between digits of which value is equal to 1 is an integer multiple of a period $\tau$ of the RSC encoding, or when the swapped data 30 (or the inputted data 2) is indicated as a sum of such values. Herein, the polynomial $g(x)$ is divisible by a predetermined generator polynomial, and this generator polynomial satisfies a condition in that, among elements included in a Galois field generated by this generator polynomial, there is no combination of at least three polynomials that are different from each other and of which a sum is 0.

Then, the polynomial $f(x)$ that indicates the configuration of the feedforward connection is selected in accordance with the selected polynomial $g(x)$. As an example, when the polynomial $g(x)$ is determined, polynomials $f(x)$ that satisfy the condition are listed, and a polynomial $f(x)$ among the listed polynomials $f(x)$ is selected so that the polynomial $h(x)$ corresponding to a specific pattern becomes the largest.

Furthermore, in an embodiment, a set of polynomials $a(x)$, that are factors that correspond at a same time to both of the feedback polynomials $g(x)$, that are selected so that the hamming weight of the parity streams 410, 420 becomes smaller than the first threshold value only when the input bit sequence (the input data 2 or the swapped data 30) satisfies the above condition, and the feedforward polynomials $f(x)$, that are selected so that the hamming weight of the parity streams 410, 420 becomes larger than the second threshold value only when the input bit sequence (the input data 2 or the swapped data 30) satisfies the above condition, will be referred to as common polynomials to use at the turbo code designing according to an embodiment, for convenience. This correspondence means that a multiplied product of the polynomials $g(x)$ and $a(x)$ satisfies the condition as the input bit sequence $b(x)$ and that a multiplied product of the polynomials $f(x)$ and $a(x)$ satisfies the condition as the output bit sequence $h(x)$. The inventor has verified that a bit error rate, that is evaluated by using only codewords included in the set determined in the above-described way, matches a computer simulation result with a sufficient accuracy. This means that there is no omission in counting patterns of main codeword that contribute to the calculation of the bit error rate.

After the step S01 in FIG. 3, the step S02 will be executed. In the step S02, the PM designing section 522 in FIG. 2 designs the PM. In more detail, the PM designing section 522 designs the PM that indicates a correspondence of inside series between the input data 2 and the swapped data 30, based on the period of the RSC encoding. This process is a part of a process of designing a rule for the interleaver 3 to generate the swapped data 30 by swapping an order of series inside the input data 2.

The period of the RSC encoding is a bit length of a circulating part when a predetermine bit and bits subsequent thereafter of an output data, that the convolutional encoder 41 outputs, circulates with a predetermined period, when an input data 2, of which a first bit is 1 and the second bit and bits subsequent thereafter are 0, is inputted into the convolutional encoder 41 that executes the RSC encoding.

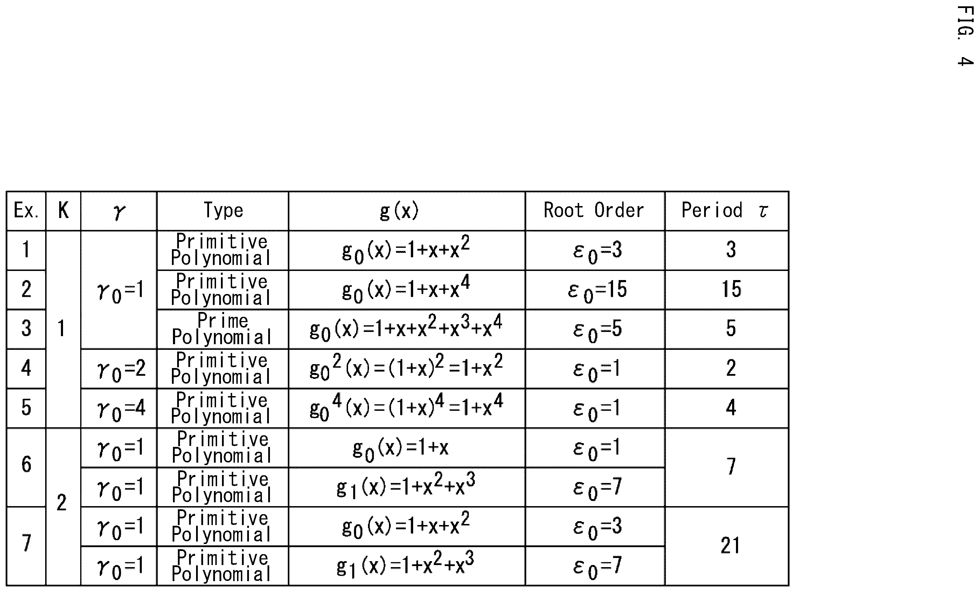

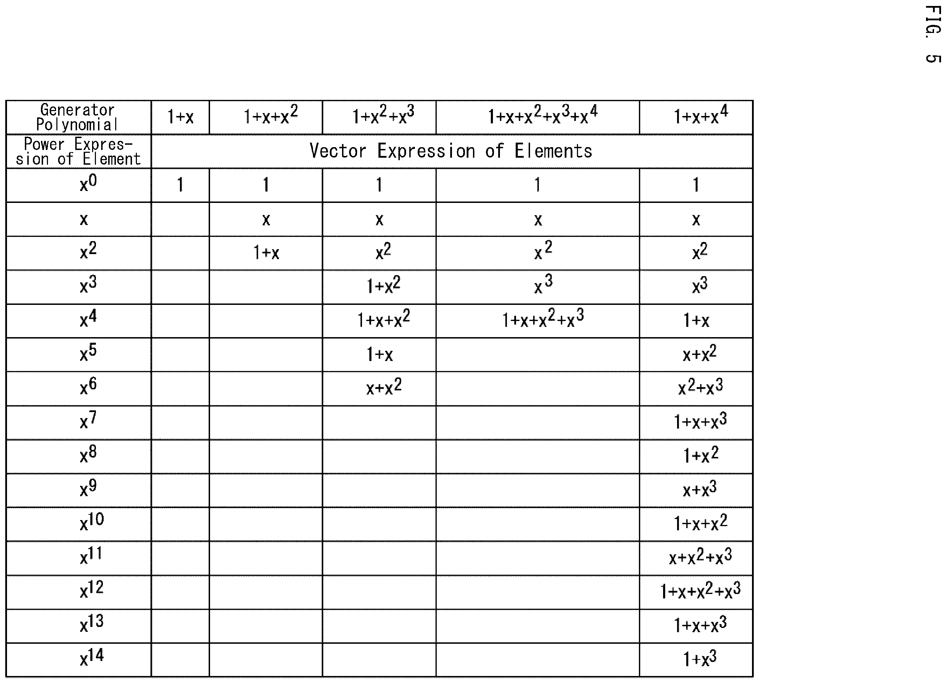

FIG. 4 is a table that shows an example of root orders and periods of a RSC encoding that respectively corresponds to a plurality of polynomials. FIG. 5 is a table that shows an example of correspondence between a generator polynomial of an RSC encoder and vector expressions of elements of each power expression of Galois field elements generated by the generator polynomial. In more detail, elements of the Galois field are generated by cosets by generator polynomials.

In an embodiment, a case in which $(37/21)_8$ is selected as the RSC encoding will be described with reference to FIG. 4 and FIG. 5. $(37/21)_8$ indicates that the polynomial that indicates the configuration of the feedforward connection is 37 in octal notation, that is, $1+x+x^2+x^3+x^4$ indicated as 11111 in binary notation, and that the polynomial that indicates the configuration of the feedback connection is 21 in octal notation, that is, $1+x^4$ indicated as 10001 in binary notation.

A case, in which the polynomial g(x) is divisible by a generator polynomial, and among elements included in the Galois field generated by this generator polynomial there is no combination of at least three polynomials that are different from each other and of which a sum is 0, will be described with reference to FIG. 5. Among the elements of a Galois field (to be precise, extended Galois field) generated by a generator polynomial in FIG. 5, elements generated by $1+x+x^2$ for example, 1, x, and 1+x are included therein. Herein, as 0 is obtained by adding 1, x, and 1+x, $1+x+x^2$ does not satisfy the above condition of the polynomial g(x). Similarly, 1, x, and 1+x are also included in elements generated by $1+x+x^4$. Herein, as 0 is obtained by adding 1, x, and 1+x, $1+x+x^4$ does not satisfy the above condition of the polynomial g(x). In addition, as 1, $x^2$, and $1+x^2$ are included in elements generated by $1+x^2+x^3$ and 0 is obtained by adding those three elements, $1+x^2+x^3$ does not satisfy the above condition of g(x). On the other hand, as 0 is not obtained by adding any combination of three elements extracted among elements generated by $1+x+x^2+x^3+x^4$, $1+x+x^2+x^3+x^4$ satisfies the above condition of g(x). It should be noted that, as there is only one element that is generated by 1+x and therefore three elements different from each other cannot be selected therefrom, 1+x satisfies the above condition of g(x).

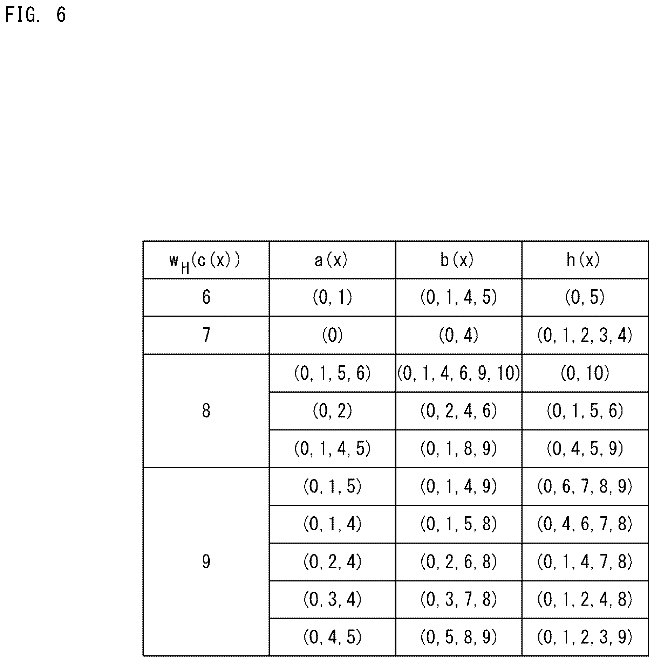

FIG. 6 is a table that shows an example, when $(37/21)_8$ is selected as RSC encoding, of hamming weight $w_H(c(x))$ of a codeword c(x), a common polynomial a(x), an input bit sequence b(x) as swapped data 30, and an output bit sequence h(x) as a parity stream 420 (also referred to as "parity check bit stream"). In the first row in FIG. 6, "b(x)" indicates an input bit sequence, "h(x)" indicates an output bit sequence, "$w_H(c(x))$" indicates a hamming weight of an output c(x) of an RSC encoding. In addition, "a(x)" satisfies "b(x)=a(x)g(x)" and "h(x)=a(x)f(x)" at a same time. Herein, "f(x)" is a function that corresponds to the feedforward connection of the delays 431, 432, 433 in the convolutional encoders 41, 42, and "g(x)" is a function that corresponds to the feedback connection of the delays 431, 432, 433 in the convolutional encoders 41, 42. In FIG. 6, in each cell in the second row and subsequent rows thereafter and in the second column and subsequent columns thereafter, integers in brackets indicate degrees of terms of which the coefficient is equal to 1 among terms included in a polynomial. As an example, "(0, 1)" indicates "$x^0+x^1$" that is "1+x", "(0, 1, 4, 5)" indicates "$x^0+x^1+x^4+x^5$" that is "$1+x+x^4+x^5$".

An example of a method of selecting a polynomial f(x) that indicates a configuration of a feedforward connection will be described by giving a specific example. A case in which there are two candidates of a polynomial g(x) that indicates a feedback connection will be considered. Herein, a first candidate is $g_1(x)=1+x+x^2$, and a second candidate is $g_2(x)=1+x^4$. In this case, the second candidate $g_2(x)$ with which the designing of the interleaver 3 becomes simpler will be selected as the polynomial g(x) that indicates the configuration of the feedback connection. At that time, there are four candidates of the polynomial f(x) that satisfy the condition. Herein, a first candidate is $f_1(x)=1+x+x^4$. A second candidate is $f_2(x)=1+x^2+x^4$. A third candidate is $f_3(x)=1+x^3+x^4$. A fourth candidate is $f_4(x)=1+x+x^2+x^3+x^4$. Among those candidates, $f_4(x)$ will be selected as a most appropriate candidate. The reason thereof is because a following "Math 5" equation holds true.

[Math 5]

$$h(x) = a(x)f(x) = \sum_{i=0}^{p-1} x^{i\tau}(1 + x + x^2 + x^3 + x^4)$$

When a length of the input data 2 is N and the period of the RSC encoding is $\tau$, PN is generated by repeatedly concatenating an intermediate matrix $\Pi$ with $\tau$ rows and $\tau$ columns $N/\tau^2$ times in a column direction. As an example, when N=32 and $\tau$=4, PM is generated as a following "Math 6" equation.

[Math 6]

$$PM = \begin{bmatrix} \Pi \\ \Pi \end{bmatrix}$$

Herein, each element of the intermediate matrix $\Pi$ is an integer from 0 to $\tau$-1. In addition, each column of the intermediate matrix $\Pi$ includes one each of integers from 0 to $\tau$-1. Such an intermediate matrix $\Pi$ is generated for example as following "Math 7" equation, "Math 8" equation or the like.

[Math 7]

$$\Pi = \begin{bmatrix} 0 & 1 & 2 & 3 \\ 1 & 2 & 3 & 0 \\ 2 & 3 & 0 & 1 \\ 3 & 0 & 1 & 2 \end{bmatrix}$$

[Math 8]

$$\Pi = \begin{bmatrix} 0 & 0 & 0 & 0 \\ 1 & 1 & 1 & 1 \\ 2 & 2 & 2 & 2 \\ 3 & 3 & 3 & 3 \end{bmatrix}$$

After the step S02 in FIG. 3, the step S03 is executed. In the step S03, the coset designing section 523 in FIG. 2 designs a coset. In more detail, the coset designing section 523 splits the input data 2 into intermediate sets that are prime to each other and of which number is equal to the period $\tau$ of the RSC encoding. At that time, elements of which a remainder of an order in series inside the input data 2 divided by the period $\tau$ is the same are assigned into a same intermediate set. When the length of the input data 2 is a multiple of the period $\tau$, a number of elements in each intermediate set becomes the same. After that, by appropriately selecting an integer prime to the period $\tau$ and by sorting elements of each intermediate set in an order equal to a remainder of a quotient of the selected integer multiplied by a coefficient that increment from 1 divided by a number of elements of the intermediate sets, cosets of a number equal to the period $\tau$ are generated.

As an example, when the length of the input data 2 is 32 bits and the period $\tau$ of the RSC encoding is equal to 4, four intermediate sets in total are generated. When the input data 2 is indicated by {0, 1, ..., 31} by using an order of an inside series thereof, four generated intermediate sets $M^0$, $M^1$, $M^2$, $M^3$ are indicated as following by using the order of the series inside the input data 2.

$$M^0 = \{0, 4, 8, 12, 16, 20, 24, 28\}$$

$$M^1 = \{1, 5, 9, 13, 17, 21, 25, 29\}$$

$$M^2 = \{2, 6, 10, 14, 18, 22, 26, 30\}$$

$$M^3 = \{3, 7, 11, 15, 19, 23, 27, 31\}$$

When 3 is selected as an integer prime to the period $\tau$, by applying the above sorting to the intermediate sets $M^0$, $M^1$, $M^2$, $M^3$, four cosets $C^0$, $C^1$, $C^2$, $C^3$ are generated as following.

$$C^0 = \{0, 12, 24, 4, 16, 28, 8, 20\}$$

$$C^1 = \{1, 13, 25, 5, 17, 29, 9, 21\}$$

$$C^2 = \{2, 14, 26, 6, 18, 30, 10, 22\}$$

$$C^3 = \{3, 15, 27, 7, 19, 31, 11, 23\}$$

The interleavers 3 that are designed as above will be referred to as coset interleavers, for convenience. By swapping the order of the series inside the input data 2 that are converted into the above cosets $C^0$, $C^1$, $C^2$, $C^3$ with the coset interleavers designed as the above "Math 6" equation and the above "Math 7" equation, the swapped data 30 is generated as following.

$$\text{Swapped data } 30 = \{0, 1, 2, 3, 13, 14, 15, 12, 26, 27, 24, 25, 7, 4, 5, 6, 16, 17, 18, 19,$$
$$29, 30, 31, 28, 10, 11, 8, 9, 23, 20, 21, 22\}$$

The inventor has verified by calculation that, as an example, when a hamming weight of the input bit sequence b(x) is 2, a hamming weight of the input data 2 inputted into the interleaver 3 becomes 14 or larger, a hamming weight of the swapped data 30 that the interleaver outputs also becomes 14 or larger, and as a result, a hamming weight of the output c(x) of the RSC encoding becomes 30 or larger.

As another example, when a hamming weight of the input bit sequence b(x) is 4, any one interleaver 3 among following three patterns is obtained.

In a first pattern, a first bit and a second bit of the input data 2 are swapped into a same coset. In the first pattern, an input bit sequence $b_4(x)$ of which the hamming weight is 4 and a swapped bit sequence $b'_4(x)$ outputted by the interleaver 3 inputted with this input bit sequence $b_4(x)$ are indicated as following "Math 9" equations.

[Math 9]

$$\begin{cases} b_4(x) = \left(1 + x^{p_2\tau^2}\right) + x^{v_2\tau^2 + v_1\tau + v_0}\left(1 + x^{q_2\tau^2}\right) \\ b'_4(x) = \left(x^{e_0^{(0)}} + x^{e_{p_2\tau}^{(0)}}\right) + \left(x^{e_{v_2\tau+v_0}^{(v_1)}} + x^{e_{(v_2+q_2)\tau+v_0}^{(v_1)}}\right) \end{cases}$$

In a second pattern, a first bit and a third bit of the input data 2 are swapped into a same coset. In the second pattern, the input bit sequence $b_4(x)$ of which the hamming weight is 4 and the swapped bit sequence $b'_4(x)$ outputted by the interleaver 3 inputted with this input bit sequence $b_4(x)$ are indicated as following "Math 10" equations.

[Math 10]

$$\begin{cases} b_4(x) = \left(1 + x^{p_2\tau^2 + p_1\tau}\right) + x^{v_2\tau^2 + v_0}\left(1 + x^{q_2\tau^2 + p_1\tau}\right) \\ b_4'(x) = \left(x^{e_0^{(0)}} + x^{e_{p_2\tau+v_0}^{(0)}}\right) + \left(x^{e_{p_2\tau}^{(p_1)}} + x^{e_{v_2'\tau+v_0}^{(p_1)}}\right) \end{cases}$$

In a third pattern, a first bit and a last bit of the input data 2 are swapped into a same coset. In the third pattern, the input bit sequence $b_4(x)$ of which the hamming weight is 4 and a swapped bit sequence $b_4'(x)$ outputted by the interleaver 3 inputted with this input bit sequence $b_4(x)$ are indicated as following "Math 11" equations.

[Math 11]

$$\begin{cases} b_4(x) = \left(1 + x^{p_2\tau^2 + p_1\tau}\right) + x^{v_2\tau^2 + p_1\tau + v_0}\left(1 + x^{(q_2+1)\tau^2 - p_1\tau}\right) \\ b_4'(x) = \left(x^{e_0^{(0)}} + x^{e_{(v_2'+1)\tau+v_0}^{(0)}}\right) + \left(x^{e_{p_2\tau}^{(p_1)}} + x^{e_{v_2'\tau+v_0}^{(p_1)}}\right) \end{cases}$$

The swapped bit sequences b'4(x) according to the above first to third patterns may be generalized as following "Math 12" equation.

[Math 12]

$$b_4'(x) = x^{R\tau}\left(1 + x^{p'\tau}\right) + x^{v'}\left(1 + x^{q'\tau}\right)$$

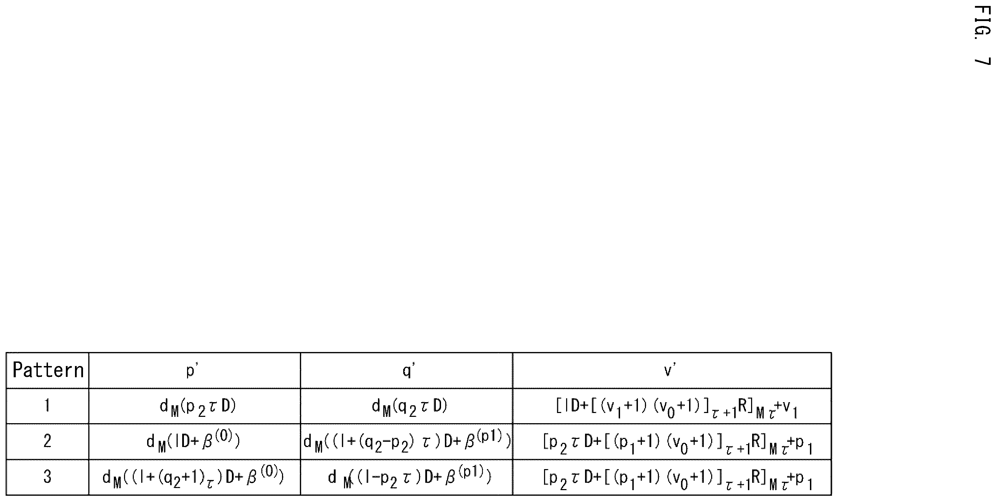

Herein, parameters "p'", "q'", and "v'" are defined as in the table in FIG. 7. "R" indicates a bias of a coset.

After the step S03 in FIG. 3, the step S04 is executed. In the step S04, the outputting section 524 in FIG. 2 outputs the turbo encoding. In more detail, the outputting section 524 outputs outside information that indicates the turbo encoding designed based on the RSC encoding selected in the step S01 and the coset interleaver designed based on the PM designed in the step S02 and the coset designed in the step S03. The outputting section 524 in FIG. 2 may output outside the information that indicates the designed turbo encoding by controlling the communication device 54.

When the step S04 in FIG. 3 ends, the process of the flowchart in FIG. 3 ends.

As described above, in the present disclosure, convolutional encoders 41, 42 are designed in the step S01 in FIG. 3, and thereafter the interleaver 3 is designed in the steps S02, S03 in FIG. 3. It is to be noticed that this order is reversed compared to related arts.

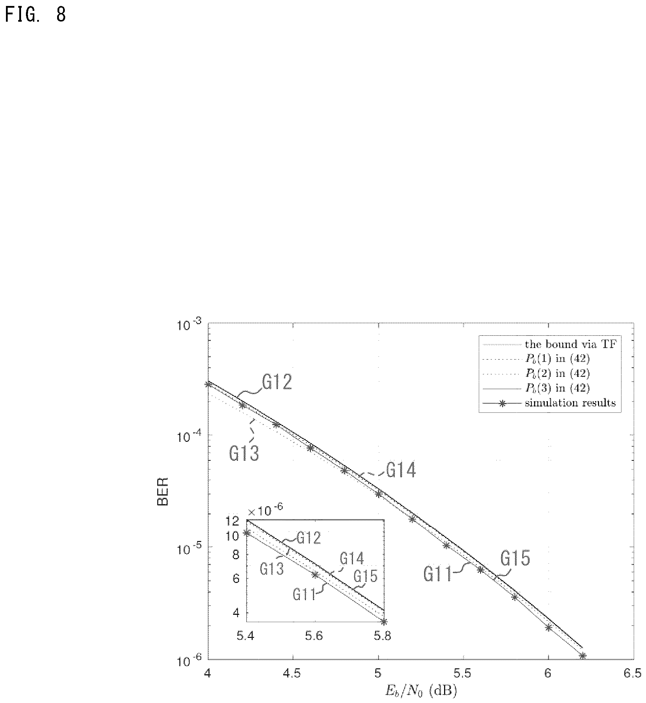

(First computer simulation) FIG. 8 is a graph that shows an example of result of a computer simulation executed to verify validity of an RSC encoding according to an embodiment. The graph in FIG. 8 includes five graphs G11, G12, G13, G14, G15 in total. The graph G11 indicates a performance of a turbo encoding that uses an RSC encoding according to an embodiment. The generator polynomial of the RSC encoding in the graph G11 is $(37/21)_8$. The graph G12 indicates an error rate bound of an RSC encoding based on a transfer function according to a related art. The graph G13 indicates a performance of a turbo encoding that uses a transformation function according to a related art when x=1 in following "Math 13" inequation. The graph G14 indicates a performance of a turbo encoding that uses a transformation function according to a related art when κ=2 in following "Math 9" inequation. The graph G15 indicates a performance of a turbo encoding that uses a transformation function according to a related art when x=3 in following "Math 9" inequation. In common to the graphs G11 to G15, horizontal axis indicates an energy-to-noise density ratio per bit in decibels (dB) and vertical axis indicates a bit error rate (BER). In addition, in common to the graphs G11 to G15, the bit length N of the input data 2 is 1024 bits.

[Math 13]

$$P_b(\kappa) \leq \frac{1}{N} \sum_{d=d_{\text{free}}}^{d_{\text{free}}+\kappa} \sum_{a(x) \in A'_c(d)} w_H\big(a(x)g(x)\big) Q\left(\sqrt{\frac{2dE_c}{N_0}}\right)$$

The above "Math 13" inequation indicates an error rate evaluation. In "Math 13" inequation, "N" indicates a bit length N per frame of the input data 2 before the encoding by the RSC encoding is executed. "$P_b(\kappa)$" indicates an average bit error rate in a received signal before decoding when the input data 2 of N bits is transferred by using the RSC encoding. To be exact, although an upper limit of a range of "d" should be set to infinity, the upper limit is herein set to "$d_{\text{free}}+\kappa$" as a realistic approximation to reduce an amount of calculation. The function "Q" indicates a probability that an error occurs. In addition, a set "$A'_c(d)$" of common polynomials a(x) is a set of common polynomials a(x) that satisfy a condition in that the hamming weight of the output sequence h(x) and the hamming weight of the input sequence b(x) are included in a predetermined range.

As it can be read from the graphs in FIG. 8, although there is some difference between the RSC encoding according to an embodiment and a transformation function according to a related art, when the energy-to-noise density ratio per bit increases, they both converge to a same value. This means that the approximation used for the RSC encoding according to an embodiment has sufficient accuracy.

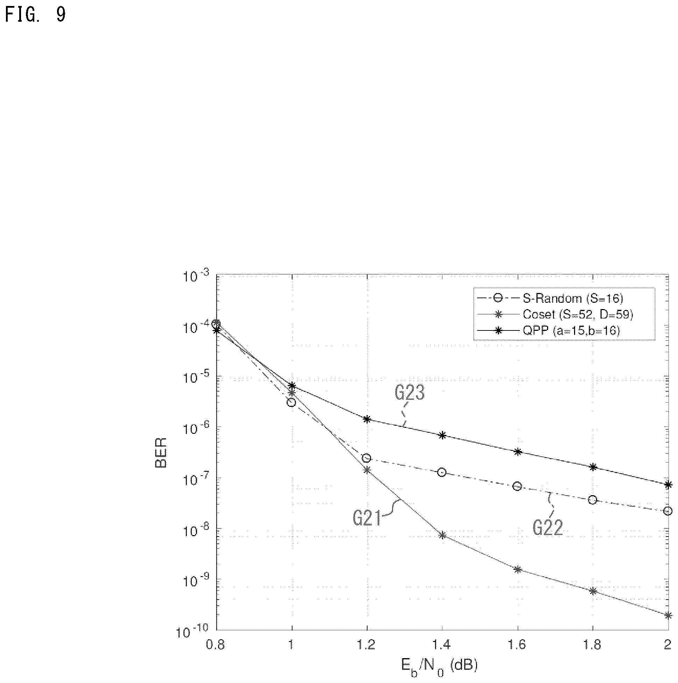

(Second computer simulation) FIG. 9 is a graph that shows an example of result of a computer simulation of performance of a turbo encoding designed by a turbo code designing method according to an embodiment. The graph in FIG. 9 includes three graphs G21, G22, G23 in total. The graph G21 indicates an example of a performance of a turbo encoding that uses a coset interleaver according to an embodiment. The graph G22 indicates an example of performance of a turbo encoder that uses a S-random interleaver. The graph G23 indicates an example of a performance of a turbo encoder that uses a QPP interleaver. In common to the graphs G21, G22, G23, the horizontal axis indicates an energy-to-noise density ratio per bit in dB, and a vertical axis indicates a BER. In addition, in common to the graphs G21, G22, G23, the bit length N of the input data 2 is 1024 bits.

As it can be read from the graphs in FIG. 9, when the bit length N of the input data 2 is 1024 bits, that is relatively long, and the energy-to-noise density ratio per bit is 1.2dB or higher, the BER of the turbo encoder that uses the coset interleaver according to an embodiment is significantly lower than the BER of the turbo encoders that use a S-random interleaver or a QPP interleaver. From this, it has been verified that, at least under the above conditions, the performance of the turbo encoder that uses the coset interleaver according to an embodiment is significantly higher than the performance of the turbo encoder that uses S-random interleaver or the QPP interleaver.

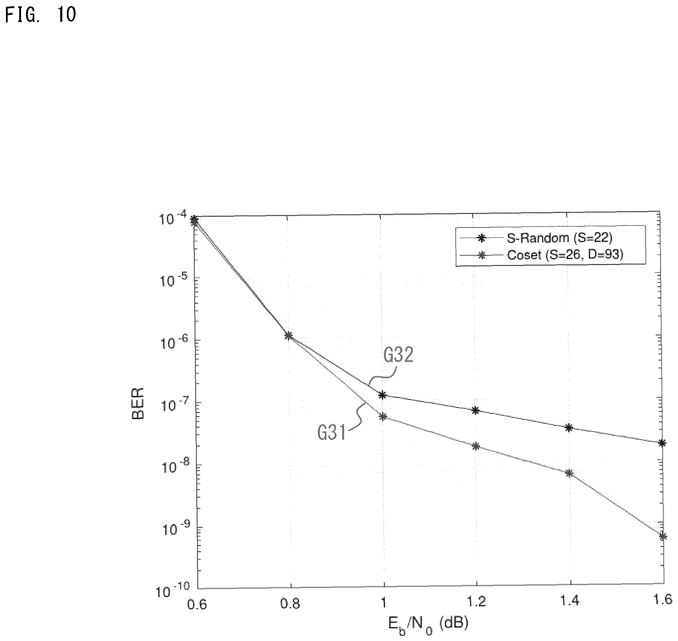

FIG. 10 is a graph that shows an example of result of a computer simulation of performance of a turbo encoding designed by a turbo code designing method according to an embodiment. The graph in FIG. 10 includes two graphs G31, G32 in total. The graph G31 indicates an example of a performance of the turbo encoder that uses the coset interleaver according to an embodiment. The graph G32 indicates an example of a performance of a turbo encoder that uses an S-random interleaver. In common to the graph G31, G32, the horizontal axis indicates an energy-to-noise density ratio per bit in dB, and the vertical axis indicates the BER. In addition, in common to the graphs G31, G32, the length N of the input data 2 is 2048 bits.

As it can be read from the graph in FIG. 10, when the bit length N of the input 2 is 2048 bits, that is longer than in the case in FIG. 9, and the energy-to-noise density ratio per bit is 0.6dB or higher, the BER of the turbo encoder that uses the coset interleaver according to an embodiment is significantly lower than the BER of the turbo encoder that uses an S-random interleaver. It is verified from this that, at least under the above conditions, the performance of the turbo encoder that use the coset interleaver according to an embodiment is significantly higher than the performance of the turbo encoder that uses an S-random interleaver.

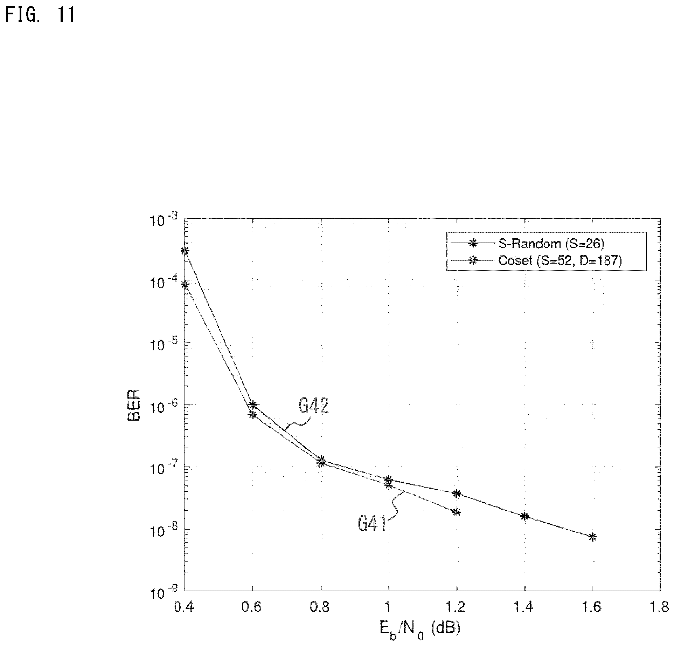

FIG. 11 is a graph that shows an example of result of a computer simulation of performance of a turbo encoding designed by a turbo code designing method according to an embodiment. The graph in FIG. 11 includes two graphs G41, G42 in total. The graph G41 indicates an example of a performance of a turbo encoder that uses a coset interleaver according to an embodiment. The graph G42 indicates an example of a performance of a turbo encoder that uses an S-random interleaver. In common to the graphs G41, G42, the horizontal axis indicates an energy-to-noise density ratio per bit in dB, and the vertical axis indicates the BER. In addition, in common to the graphs G41, G42, the bit length N of the input data 2 is 4096 bits.

As it can be read from the graph in FIG. 11, when the bit length N of the input data 2 is 4096 bits, that is longer than in the case in FIG. 10, and the energy-to-noise density ratio per bit is 0.4dB or larger, the BER of the turbo encoding that uses the coset interleaver according to an embodiment is significantly lower than the BER of the turbo encoder that uses an S-random interleaver. It is verified from this that, under the above conditions, the performance of the turbo encoder that uses the coset interleaver according to an embodiment is significantly higher than the performance of the turbo encoder that uses an S-random interleaver.

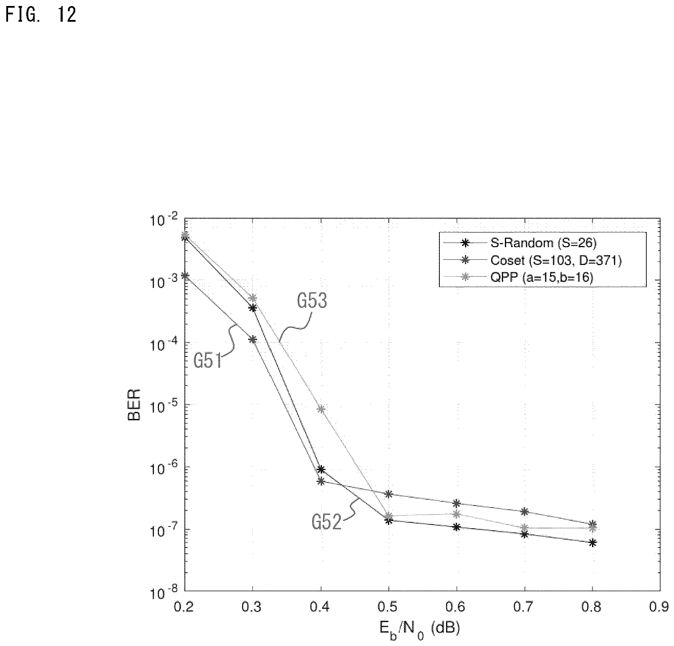

FIG. 12 is a graph that shows an example of result of a computer simulation of performance of a turbo encoding designed by a turbo code designing method according to an embodiment. The graph in FIG. 12 includes three graphs G51, G52, G53 in total. The graph G51 indicates an example of a performance of the turbo encoder that uses the coset interleaver according to an embodiment. The graph G52 indicates an example of a performance of a turbo encoder that uses an S-random interleaver. The graph G53 indicates an example of a performance of a turbo encoder that uses a QPP interleaver. In common to the graphs G51, G52, G53, the horizontal axis indicates an energy-to-noise density ratio per bit in dB, and the vertical axis indicates the BER. In addition, in common to the graphs G51, G52, G53, the bit length N of the input data 2 is 8192 bits.

As it can be read from the graph in FIG. 12, when the bit length N of the input data 2 is 8192 bits, that is longer than in the case in FIG. 11, and the energy-to noise density ratio per bit is 0.4dB or lower, the BER of the turbo encoder that uses the coset interleaver according to an embodiment is significantly lower than the BER of the turbo encoder that uses an S-random interleaver. It has been verified from this that, at least under the above conditions, the performance of the turbo encoder that uses the coset interleaver according to an embodiment is significantly higher than the performance of the turbo encoder that uses an S-random interleaver.

As described above, the turbo encoder that uses the coset interleaver designed by using the turbo code designing method, the turbo code designing apparatus 5, and the turbo designing program according to the present disclosure has a performance higher than a turbo encoder that uses an S-random interleaver or a QPP interleaver, at least under the conditions in the above simulations. Furthermore, the inventor has verified by computer simulations that, in the turbo encoding according to an embodiment, when different values for each coset are set as a depth D and a bias R, a performance better than a turbo encoder that uses an S-random interleaver can be obtained, even when the bit length N of the input data 2 is extended to 16832 bits.

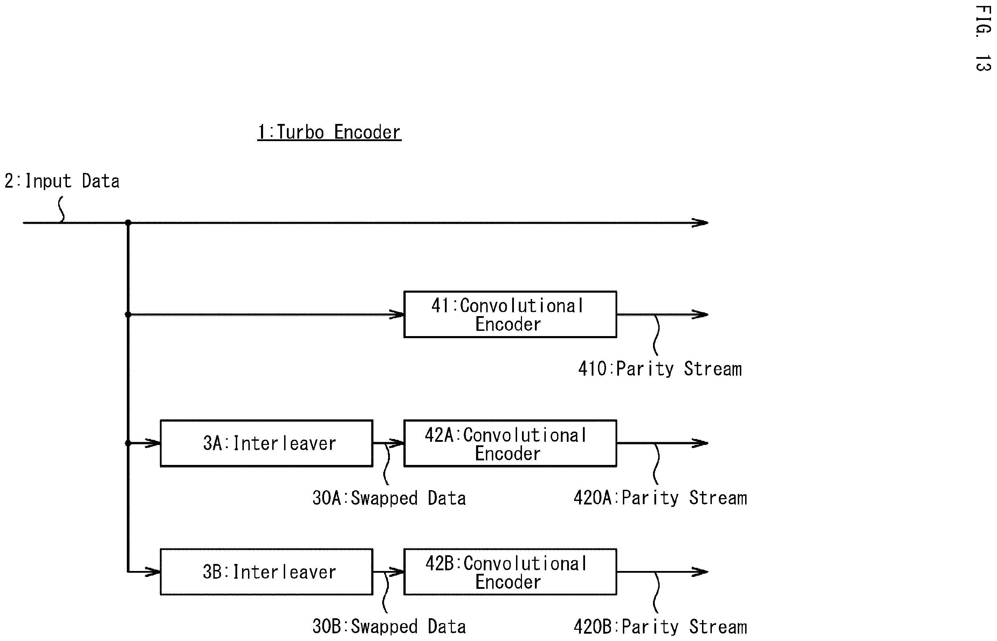

(First variation) In the embodiment described above, as shown in FIG. 1A, a configuration of a case in which the turbo encoder 1 is provided with one interleaver and two convolutional encoders 41, 42 has been described. As an example of variation of this configuration, as shown in FIG. 13, the turbo encoder 1 may be provided with two interleavers 3A, 3B and three convolutional encoders 41, 42A, 42B.

The first convolutional encoder 41 in FIG. 13 is configured similarly to the first convolutional encoder 41 in FIG. 1A and FIG. 1B, is provided with the input data 2, and outputs the first parity stream 410. The first parity stream 410 in FIG. 13 is the same as the first parity stream 410 in FIG. 1A and FIG. 1B.

The first interleaver 3A in FIG. 13 is configured similarly to the interleaver 3 in FIG. 1A, is provided with the input data 2, and outputs a first swapped data 30A. The first swapped data 30A in FIG. 13 is same as the swapped data 30 in FIG. 1A and FIG. 1B. The second convolutional encoder 42A in FIG. 13 is configured similarly to the second convolutional encoder 42 in FIG. 1A, is provided with the first swapped data 30A, and outputs the second parity stream 420. The second parity stream 420A in FIG. 13 is same as the second parity stream 420 in FIG. 1A and FIG. 1B.

The second interleaver 3B in FIG. 13 is provided with the input data 2 and outputs a second swapped data 30B based on a rule different from the first interleaver 3A in FIG. 13. The second swapped data 30B in FIG. 13 is different from the first swapped data 30A in FIG. 13. The third convolutional encoder 42B in FIG. 13 is configured similarly to the second convolutional encoder 42A in FIG. 13, is provided with the second swapped data 30B, and outputs a third parity stream 420B. The third parity stream 420B in FIG. 13 is different from the second parity stream 420A in FIG. 13.

The turbo encoder 1 in FIG. 13 is provided with a coupler that is not illustrated, similarly to the turbo encoder 1 in FIG. 1A. This coupler generates output data that is the turbo-encoded input data 2, based on the input data 2, the first parity stream 410, the second parity stream 420A, and the third parity stream 420B. The coupler may generate intermediate data by partially decimating and multiplexing the parity streams 410, 420A, 420B, and generate the output data by multiplexing the intermediate data and the input data 2.

When the interleavers 3A, 3B in FIG. 13 are not distinguished, they will be referred to as interleavers 3. When the swapped data 30A, 30B in FIG. 13 are not distinguished, they will be referred to as swapped data 30. When the convolutional encoders 42A, 42B in FIG. 13 are not distinguished, they will be referred to as convolutional encoders 42. When the parity streams 420A, 420B in FIG. 13 are not distinguished, they will be referred to as parity streams 420. Even in case of above-described generalization, relationship between the interleavers 3, the swapped data 30, the convolutional encoders 42, and parity streams 420 is same as that described with reference to FIG. 1B.

It should be noted that, as a further variation of the configuration in FIG. 13, further sets of an interleaver 3 and a convolutional encoder 42 may be added in parallel.

The invention made by the inventor has been described above in detail based on embodiments; however, it is obvious that the present invention is not limited to the embodiments and that various modifications can be made within a range of not departing from the gist thereof. In addition, each feature described in embodiments can be freely combined within a range of not technically contradicting.

The present invention claims priority based on Japanese patent application No. 2022-182371 filed on November 15, 2022, the whole disclosure of which is incorporated herein.

**Claims**

1. A turbo code designing method for designing turbo encoding,

   wherein a turbo encoder configured to execute the turbo encoding comprises:

   > a first convolutional encoder configured to generate a parity stream of input data as a first parity stream by use of a predetermined recursive systematic convolutional (RSC) encoding;
   > an interleaver configured to swap an order of series inside the input data based on a first rule to generate swapped data; and
   > a second convolutional encoder configured to generate a parity stream of the swapped data as a second parity stream by use of the RSC encoding,

   the method including:

   > selecting a polynomial that indicates the RSC encoding among elements of a Galois field generated by a generator polynomial;
   > designing the first rule of the interleaver based on the RSC encoding; and
   > outputting information that indicates the designed turbo encoding outside,

   wherein the polynomial that indicates the RSC encoding includes a feedforward polynomial that indicates a feedforward connection and a feedback polynomial that indicates a feedback connection, and
   wherein each of the feedforward polynomial and the feedback polynomial is a polynomial selected among the elements of the Galois field or a multiplied product of a plurality of polynomials selected among the elements of the Galois field.

2. The turbo code designing method according to claim 1,

   wherein the second convolutional encoder comprises:

   > a plurality of delays connected in series;
   > a first group of adders configured to connects feedforward an output of a part of the plurality of delays to an output of the second convolutional encoder; and
   > a second group of adders configured to connect feedback an output of a part of the plurality of delays to an input of the second convolutional encoder,

   wherein the selecting the polynomial that indicates the RSC encoding includes:

   > selecting a feedback polynomial g(x) that indicates a configuration of the feedback connection, so that a hamming weight of a parity stream that the second convolutional encoder outputs is smaller than a predetermined first threshold value only when the swapped data inputted into the second convolutional encoder satisfies a predetermined condition; and
   > selecting a feedforward polynomial f(x) that indicates a configuration of the feedforward connection, so that the hamming weight of the parity stream that the second convolutional encoder outputs is larger than a predetermined second threshold value only when the swapped data inputted into the second convolutional encoder satisfies the predetermined condition,

   wherein the predetermined condition includes:

   > the swapped data is a value in which a distance between digits of which a value is equal to 1 in a binary notation of the swapped data is an integer multiple of a period of the RSC encoding, or, a sum of a plurality of values in each of which a distance between digits of which a value is equal to 1 in the binary notation of the swapped data is an integer multiple of the period of the RSC encoding; and

the feedback polynomial g(x) is divisible by a predetermined generator polynomial, and no combination of at least three polynomials that are different from each other and of which a sum is zero exists in elements of the Galois field generated by the predetermined generator polynomial.

3. The turbo code designing method according to claim 2,
   wherein the first threshold value is a value calculated based on a desired free distance in the turbo encoding.

4. The turbo code designing method according to claim 3,
   wherein the first threshold value is 42.

5. The turbo code designing method according to any one of claims 2 to 4,
   wherein a configuration of the first convolutional encoder is same as a configuration of the second convolutional encoder.

6. The turbo designing method according to claim 5,

   wherein the designing the first rule of the interleaver includes:

   designing a permutation matrix (PM) that indicates a correspondence of an order of inside series between the input data and the swapped data, based on the period of the RSC encoding; and
   generating a plurality of sets that are prime to each other by splitting the input data as a plurality of cosets, based on the period of the RSC encoding, and

   wherein the period of the RSC encoding is a bit length of a circulating part when a predetermined bit and subsequent bits thereafter of an output data of the RSC encoding inputted with an input data of which a first bit is 1 and a second bit and subsequent bits thereafter are 0 circulates at a predetermined period.

7. The turbo code designing method according to claim 6,
   wherein the designing the PM includes:

   generating, when the period of the RSC encoding is $\tau$, a first matrix with $\tau$ rows and $\tau$ columns, in which each element is any one of integers from 0 to $\tau$-1, and each column includes one each of integers from 0 to $\tau$-1; and
   generating, as the PM, a second matrix in which the first matrix is repeatedly concatenated in row direction, based on the period and a length of the input data.

8. The turbo code designing method according to claim 7,

   wherein the generating the plurality of sets as the plurality of cosets includes:

   splitting the input data into a plurality of intermediate sets that are prime to each other and of which number is equal to the period of the RSC encoding; and
   generating the plurality of cosets by swapping an order of a plurality of elements in each of the plurality of intermediate sets,

   wherein the splitting includes:
   assigning elements, of the elements included in the input data, of which a remainder of an order in series inside the input data divided by the period is the same, into a same intermediate set of the plurality of intermediate sets,
   wherein the swapping the order includes:

   preparing an integer prime to the period in the each of the plurality of intermediate sets;
   preparing a coefficient that increments from 1; and
   sorting elements of the each of the plurality of intermediate sets in an order equal to a remainder of a multiplied quotient of the integer multiplied and the coefficient divided by a number of elements of the each of the plurality of intermediate sets.

9. The turbo code designing method according to claim 1,
wherein a bit length of the input data is equal to or less than 16384 bits.

10. The turbo code designing method according to claim 1,
wherein a bit length of the input data is equal to or less than 8192 bits.

11. The turbo code designing method according to claim 1,
wherein a bit length of the input data is equal to or less than 1024 bits.

12. The turbo code designing method according to claim 2,
wherein, when a hamming weight of an inputted bit sequence inputted into the second convolutional encoder by a feedback connection is 2, a hamming weight of an input data inputted into the interleaver is equal to or larger than 14, and a hamming weight of the swapped data that the interleaver outputs is equal to or larger than 14.

13. The turbo code designing method according to claim 1,

wherein the turbo encoder further comprises:

a second interleaver different from the interleaver as a first interleaver, configured to swap an order of series inside the input data based on a second rule different from the first rule to generate a second swapped data different from the swapped data as a first swapped data; and
a third convolutional encoder configured to generate a parity stream of the second swapped data as a third parity stream, and

wherein the method further includes:
designing the second rule of the second interleaver based on the RSC encoding.

14. A turbo code designing apparatus configured to design a turbo encoding,

wherein a turbo encoder configured to execute the turbo encoding comprises:

a first convolutional encoder configured to generate a parity stream of input data by a predetermined RSC encoding as a first parity stream;
an interleaver configured to swap an order of series inside the input data based on a first rule to generate swapped data; and
a second convolutional encoder configured to generate a parity stream of the swapped data as a second parity stream by use of the RSC encoding,

wherein the turbo code designing apparatus comprises:

an RSC code selecting section configured to select a polynomial that indicates the RSC encoding among elements of a Galois field generated by a generator polynomial;
a PM designing section configured to design a PM that indicates a correspondence of an order of inside series between the input data and the swapped data, based on a period of the RSC encoding;
a coset designing section configured to design a second rule for generating a plurality of sets that are prime to each other as a plurality of cosets by splitting the input data, based on the period of the RSC encoding; and
an outputting section configured to output information that indicates the designed turbo encoding outside,

wherein the polynomial the indicates the RSC encoding includes a feedforward polynomial that indicates a feedforward connection and a feedback polynomial that indicates a feedback connection,
wherein each of the feedforward polynomial and the feedback polynomial is a polynomial selected among the elements of the Galois field or a multiplied product of a plurality of polynomials selected among the elements of the Galois field, and
wherein the period of the RSC encoding is a bit length of a circulating part when a predetermined bit and subsequent bits thereafter of an output data of the RSC encoding inputted with an input data of which a first bit is 1 and a second bit and subsequent bits thereafter are 0 circulates at a predetermined period.

15. A recording medium stored with a turbo code designing program that realizes, by making a processor execute, a process for designing a turbo encoding,

wherein a turbo encoder configured to execute the turbo encoding comprises:

a first convolutional encoder configured to generate a parity stream of input data as a first parity stream by use of a predetermined RSC encoding;
an interleaver configured to swap an order of series inside the input data based on a first rule to generate swapped data; and
a second convolutional encoder configured to generate a parity stream of the swapped data as a second parity stream by use of the RSC encoding,

the process includes:

selecting a polynomial that indicates the RSC encoding among elements of a Galois field generated by a generator polynomial;
designing the first rule of the interleaver based on the RSC encoding; and
outputting information that indicates the designed turbo encoding outside,

wherein the polynomial that indicates the RSC encoding includes a feedforward polynomial that indicates a feedforward connection and a feedback polynomial that indicates a feedback connection, and
wherein each of the feedforward polynomial and the feedback polynomial is a polynomial selected among the elements of the Galois field or a multiplied product of a plurality of polynomials selected among the elements of the Galois field.

**Amended claims under Art. 19.1 PCT**

**1.** (Amended) A turbo code designing method for designing turbo encoding,

wherein a turbo encoder configured to execute the turbo encoding comprises:

a first convolutional encoder configured to generate a parity stream of input data as a first parity stream by use of a predetermined recursive systematic convolutional (RSC) encoding;
an interleaver configured to swap an order of series inside the input data based on a first rule to generate swapped data; and
a second convolutional encoder configured to generate a parity stream of the swapped data as a second parity stream by use of the RSC encoding,

the method including:

selecting a polynomial that indicates the RSC encoding among elements of a Galois field generated by a generator polynomial;
designing the first rule of the interleaver based on the RSC encoding; and
outputting information that indicates the designed turbo encoding outside,

wherein the polynomial that indicates the RSC encoding includes a feedforward polynomial that indicates a feedforward connection and a feedback polynomial that indicates a feedback connection,
wherein each of the feedforward polynomial and the feedback polynomial is a polynomial selected among the elements of the Galois field or a multiplied product of a plurality of polynomials selected among the elements of the Galois field,
wherein the second convolutional encoder comprises:

a plurality of delays connected in series;
a first group of adders configured to connects feedforward an output of a part of the plurality of delays to an output of the second convolutional encoder; and
a second group of adders configured to connect feedback an output of a part of the plurality of delays to an input of the second convolutional encoder,

wherein the selecting the polynomial that indicates the RSC encoding includes:

selecting a feedback polynomial g(x) that indicates a configuration of the feedback connection so that a hamming weight of a parity stream that the second convolutional encoder outputs is smaller than a predetermined first threshold value only when the swapped data inputted into the second convolutional encoder satisfies a predetermined condition; and
selecting a feedforward polynomial f(x) that indicates a configuration of the feedforward connection, so that the hamming weight of the parity stream that the second convolutional encoder outputs is larger than a predetermined second threshold value only when the swapped data inputted into the second convolutional encoder satisfies the predetermined condition,

wherein the predetermined condition includes:

the swapped data is a value in which a distance between digits of which a value is equal to 1 in a binary notation of the swapped data is an integer multiple of a period of the RSC encoding, or, a sum of a plurality of values in each of which a distance between digits of which a value is equal to 1 in the binary notation of the swapped data is an integer multiple of the period of the RSC encoding; and
the feedback polynomial g(x) is divisible by a predetermined generator polynomial, and no combination of at least three polynomials that are different from each other and of which a sum is zero exists in elements of the Galois field generated by the predetermined generator polynomial.

3. (Amended) The turbo code designing method according to claim 1,
wherein the first threshold value is a value calculated based on a desired free distance in the turbo encoding.

4. The turbo code designing method according to claim 3,
wherein the first threshold value is 42.

5. (Amended) The turbo code designing method according to any one of claims 1, 3 or 4,
wherein a configuration of the first convolutional encoder is same as a configuration of the second convolutional encoder.

6. The turbo designing method according to claim 5,

wherein the designing the first rule of the interleaver includes:

designing a permutation matrix (PM) that indicates a correspondence of an order of inside series between the input data and the swapped data, based on the period of the RSC encoding; and
generating a plurality of sets that are prime to each other by splitting the input data as a plurality of cosets, based on the period of the RSC encoding, and

wherein the period of the RSC encoding is a bit length of a circulating part when a predetermined bit and subsequent bits thereafter of an output data of the RSC encoding inputted with an input data of which a first bit is 1 and a second bit and subsequent bits thereafter are 0 circulates at a predetermined period.

7. The turbo code designing method according to claim 6,
wherein the designing the PM includes:

generating, when the period of the RSC encoding is $\tau$, a first matrix with $\tau$ rows and $\tau$ columns, in which each element is any one of integers from 0 to $\tau$-1, and each column includes one each of integers from 0 to $\tau$-1; and
generating, as the PM, a second matrix in which the first matrix is repeatedly concatenated in row direction, based on the period and a length of the input data.

8. The turbo code designing method according to claim 7,

wherein the generating the plurality of sets as the plurality of cosets includes:

splitting the input data into a plurality of intermediate sets that are prime to each other and of which number is equal to the period of the RSC encoding; and
generating the plurality of cosets by swapping an order of a plurality of elements in each of the plurality of intermediate sets,

wherein the splitting includes:
assigning elements, of the elements included in the input data, of which a remainder of an order in series inside the input data divided by the period is the same, into a same intermediate set of the plurality of intermediate sets, wherein the swapping the order includes:

preparing an integer prime to the period in the each of the plurality of intermediate sets;
preparing a coefficient that increments from 1; and
sorting elements of the each of the plurality of intermediate sets in an order equal to a remainder of a multiplied quotient of the integer multiplied and the coefficient divided by a number of elements of the each of the plurality of intermediate sets.

**9.** The turbo code designing method according to claim 1,
wherein a bit length of the input data is equal to or less than 16384 bits.

**10.** The turbo code designing method according to claim 1,
wherein a bit length of the input data is equal to or less than 8192 bits.

**11.** The turbo code designing method according to claim 1,
wherein a bit length of the input data is equal to or less than 1024 bits.

**12.** (Amended) The turbo code designing method according to claim 1,
wherein, when a hamming weight of an inputted bit sequence inputted into the second convolutional encoder by a feedback connection is 2, a hamming weight of an input data inputted into the interleaver is equal to or larger than 14, and a hamming weight of the swapped data that the interleaver outputs is equal to or larger than 14.

**13.** The turbo code designing method according to claim 1,

wherein the turbo encoder further comprises:

a second interleaver different from the interleaver as a first interleaver, configured to swap an order of series inside the input data based on a second rule different from the first rule to generate a second swapped data different from the swapped data as a first swapped data; and
a third convolutional encoder configured to generate a parity stream of the second swapped data as a third parity stream by use of the RSC encoding, and

wherein the method further includes:
designing the second rule of the second interleaver based on the RSC encoding.

**14.** (Amended) A turbo code designing apparatus configured to design a turbo encoding,

wherein a turbo encoder configured to execute the turbo encoding comprises:

a first convolutional encoder configured to generate a parity stream of input data by a predetermined RSC encoding as a first parity stream;
an interleaver configured to swap an order of series inside the input data based on a first rule to generate swapped data; and
a second convolutional encoder configured to generate a parity stream of the swapped data as a second parity stream by use of the RSC encoding,

wherein the turbo code designing apparatus comprises:

an RSC code selecting section configured to select a polynomial that indicates the RSC encoding among elements of a Galois field generated by a generator polynomial;
a PM designing section configured to design a PM that indicates a correspondence of an order of inside series between the input data and the swapped data, based on a period of the RSC encoding;
a coset designing section configured to design a second rule for generating a plurality of sets that are prime to each other as a plurality of cosets by splitting the input data, based on the period of the RSC encoding; and
an outputting section configured to output information that indicates the designed turbo encoding outside,

wherein the polynomial the indicates the RSC encoding includes a feedforward polynomial that indicates a feedforward connection and a feedback polynomial that indicates a feedback connection,

wherein each of the feedforward polynomial and the feedback polynomial is a polynomial selected among the elements of the Galois field or a multiplied product of a plurality of polynomials selected among the elements of the Galois field, and

wherein the period of the RSC encoding is a bit length of a circulating part when a predetermined bit and subsequent bits thereafter of an output data of the RSC encoding inputted with an input data of which a first bit is 1 and a second bit and subsequent bits thereafter are 0 circulates at a predetermined period,

wherein the second convolutional encoder comprises:

a plurality of delays connected in series;
a first group of adders configured to connects feedforward an output of a part of the plurality of delays to an output of the second convolutional encoder; and
a second group of adders configured to connect feedback an output of a part of the plurality of delays to an input of the second convolutional encoder,

wherein the RSC code selecting section is further configured to:

select a feedback polynomial $g(x)$ that indicates a configuration of the feedback connection so that a hamming weight of a parity stream that the second convolutional encoder outputs is smaller than a predetermined first threshold value only when the swapped data inputted into the second convolutional encoder satisfies a predetermined condition; and
select a feedforward polynomial $f(x)$ that indicates a configuration of the feedforward connection, so that the hamming weight of the parity stream that the second convolutional encoder outputs is larger than a predetermined second threshold value only when the swapped data inputted into the second convolutional encoder satisfies the predetermined condition,

wherein the predetermined condition includes:

the swapped data is a value in which a distance between digits of which a value is equal to 1 in a binary notation of the swapped data is an integer multiple of a period of the RSC encoding, or, a sum of a plurality of values in each of which a distance between digits of which a value is equal to 1 in the binary notation of the swapped data is an integer multiple of the period of the RSC encoding; and
the feedback polynomial $g(x)$ is divisible by a predetermined generator polynomial, and no combination of at least three polynomials that are different from each other and of which a sum is zero exists in elements of the Galois field generated by the predetermined generator polynomial.

**15.** (Amended) A recording medium stored with a turbo code designing program that realizes, by making a processor execute, a process for designing a turbo encoding,

wherein a turbo encoder configured to execute the turbo encoding comprises:

a first convolutional encoder configured to generate a parity stream of input data as a first parity stream by use of a predetermined RSC encoding;
an interleaver configured to swap an order of series inside the input data based on a first rule to generate swapped data; and
a second convolutional encoder configured to generate a parity stream of the swapped data as a second parity stream by use of the RSC encoding,

the process includes:

selecting a polynomial that indicates the RSC encoding among elements of a Galois field generated by a generator polynomial;
designing the first rule of the interleaver based on the RSC encoding; and
outputting information that indicates the designed turbo encoding outside,

wherein the polynomial that indicates the RSC encoding includes a feedforward polynomial that indicates a feedforward connection and a feedback polynomial that indicates a feedback connection, and

wherein each of the feedforward polynomial and the feedback polynomial is a polynomial selected among the elements of the Galois field or a multiplied product of a plurality of polynomials selected among the elements of the Galois field,

wherein the second convolutional encoder comprises:

a plurality of delays connected in series,
a first group of adders configured to connects feedforward an output of a part of the plurality of delays to an output of the second convolutional encoder; and
a second group of adders configured to connect feedback an output of a part of the plurality of delays to an input of the second convolutional encoder,

wherein the selecting the polynomial that indicates the RSC encoding includes:

selecting a feedback polynomial $g(x)$ that indicates a configuration of the feedback connection so that a hamming weight of a parity stream that the second convolutional encoder outputs is smaller than a predetermined first threshold value only when the swapped data inputted into the second convolutional encoder satisfies a predetermined condition: and
selecting a feedforward polynomial $f(x)$ that indicates a configuration of the feedforward connection, so that the hamming weight of the parity stream that the second convolutional encoder outputs is larger than a predetermined second threshold value only when the swapped data inputted into the second convolutional encoder satisfies the predetermined condition,

wherein the predetermined condition includes:

the swapped data is a value in which a distance between digits of which a value is equal to 1 in a binary notation of the swapped data is an integer multiple of a period of the RSC encoding, or, a sum of a plurality of values in each of which a distance between digits of which a value is equal to 1 in the binary notation of the swapped data is an integer multiple of the period of the RSC encoding; and
the feedback polynomial $g(x)$ is divisible by a predetermined generator polynomial, and no combination of at least three polynomials that are different from each other and of which a sum is zero exists in elements of the Galois field generated by the predetermined generator polynomial.

FIG. 1A

1:Turbo Encoder

2:Input Data

41:Convolutional
Encoder

410:Parity Stream

3:Interleaver

42:Convolutional
Encoder

30:Swapped Data

420:Parity Stream

FIG. 1B

41:Convolutional Encoder (42:Convolutional Encoder)

410:Parity Stream
(420:Parity Stream)

431:Delay

432:Delay

433:Delay

2:Input Data
(30:Swapped Data)

FIG. 2

5:Turbo Code Designing Apparatus

51:Bus

52:Processor

521:RSC Code Selection Section

522:PM Designing Section

523:Coset Designing Section

524:Outputting Section

530:Recording Medium

53:Memory Device

54:Communication Device

55:Input Output Device

FIG. 3

```
        ( Start )
            │
            ▼
┌───────────────────────────┐  S01
│   Selecting RSC Encoding  │
└───────────────────────────┘
            │
            ▼
┌───────────────────────────┐  S02
│       Designing PM        │
└───────────────────────────┘
            │
            ▼
┌───────────────────────────┐  S03
│     Designing Coset       │
└───────────────────────────┘
            │
            ▼
┌───────────────────────────┐  S04
│ Outputting Turbo Encoding │
└───────────────────────────┘
            │
            ▼
         ( End )
```

FIG. 4

| Ex. | K | $\gamma$ | Type | $g(x)$ | Root Order | Period $\tau$ |
|---|---|---|---|---|---|---|
| 1 | 1 | $\gamma_0=1$ | Primitive Polynomial | $g_0(x)=1+x+x^2$ | $\varepsilon_0=3$ | 3 |
| 2 | | $\gamma_0=1$ | Primitive Polynomial | $g_0(x)=1+x+x^4$ | $\varepsilon_0=15$ | 15 |
| 3 | | | Prime Polynomial | $g_0(x)=1+x+x^2+x^3+x^4$ | $\varepsilon_0=5$ | 5 |
| 4 | | $\gamma_0=2$ | Primitive Polynomial | $g_0^2(x)=(1+x)^2=1+x^2$ | $\varepsilon_0=1$ | 2 |
| 5 | | $\gamma_0=4$ | Primitive Polynomial | $g_0^4(x)=(1+x)^4=1+x^4$ | $\varepsilon_0=1$ | 4 |
| 6 | 2 | $\gamma_0=1$ | Primitive Polynomial | $g_0(x)=1+x$ | $\varepsilon_0=1$ | 7 |
| | | $\gamma_0=1$ | Primitive Polynomial | $g_1(x)=1+x^2+x^3$ | $\varepsilon_0=7$ | |
| 7 | | $\gamma_0=1$ | Primitive Polynomial | $g_0(x)=1+x+x^2$ | $\varepsilon_0=3$ | 21 |
| | | $\gamma_0=1$ | Primitive Polynomial | $g_1(x)=1+x^2+x^3$ | $\varepsilon_0=7$ | |

FIG. 5

| Power Expression of Element | Generator Polynomial | | | | |
| | 1+x | 1+x+x² | 1+x²+x³ | 1+x+x²+x³+x⁴ | 1+x+x⁴ |
| | Vector Expression of Elements | | | | |
|---|---|---|---|---|---|
| $x^0$ | $1$ | $1$ | $1$ | $1$ | $1$ |
| $x$ |  | $x$ | $x$ | $x$ | $x$ |
| $x^2$ |  | $1+x$ | $x^2$ | $x^2$ | $x^2$ |
| $x^3$ |  |  | $1+x^2$ | $x^3$ | $x^3$ |
| $x^4$ |  |  | $1+x+x^2$ | $1+x+x^2+x^3$ | $1+x$ |
| $x^5$ |  |  | $1+x$ |  | $x+x^2$ |
| $x^6$ |  |  | $x+x^2$ |  | $x^2+x^3$ |
| $x^7$ |  |  |  |  | $1+x+x^3$ |
| $x^8$ |  |  |  |  | $1+x^2$ |
| $x^9$ |  |  |  |  | $x+x^3$ |
| $x^{10}$ |  |  |  |  | $1+x+x^2$ |
| $x^{11}$ |  |  |  |  | $x+x^2+x^3$ |
| $x^{12}$ |  |  |  |  | $1+x+x^2+x^3$ |
| $x^{13}$ |  |  |  |  | $1+x^2+x^3$ |
| $x^{14}$ |  |  |  |  | $1+x^3$ |

FIG. 6

| $w_H(c(x))$ | a(x) | b(x) | h(x) |
|---|---|---|---|
| 6 | (0, 1) | (0, 1, 4, 5) | (0, 5) |
| 7 | (0) | (0, 4) | (0, 1, 2, 3, 4) |
| 8 | (0, 1, 5, 6) | (0, 1, 4, 6, 9, 10) | (0, 10) |
| | (0, 2) | (0, 2, 4, 6) | (0, 1, 5, 6) |
| | (0, 1, 4, 5) | (0, 1, 8, 9) | (0, 4, 5, 9) |
| 9 | (0, 1, 5) | (0, 1, 4, 9) | (0, 6, 7, 8, 9) |
| | (0, 1, 4) | (0, 1, 5, 8) | (0, 4, 6, 7, 8) |
| | (0, 2, 4) | (0, 2, 6, 8) | (0, 1, 4, 7, 8) |
| | (0, 3, 4) | (0, 3, 7, 8) | (0, 1, 2, 4, 8) |
| | (0, 4, 5) | (0, 5, 8, 9) | (0, 1, 2, 3, 9) |

FIG. 7

| Pattern | p' | q' | v' |
|---|---|---|---|
| 1 | $d_M(p_2 \tau D)$ | $d_M(q_2 \tau D)$ | $[ID+[(v_1+1)(v_0+1)]_\tau 1R]_M \tau+v_1$ |
| 2 | $d_M(ID+\beta^{(0)})$ | $d_M((1+(q_2-p_2))\tau D+\beta^{(p1)})$ | $[p_2 \tau D+[(p_1+1)(v_0+1)]_\tau 1R]_M \tau+p_1$ |
| 3 | $d_M((1+(q_2+1))_\tau 1 D+\beta^{(0)})$ | $d_M((1-p_2)\tau D+\beta^{(p1)})$ | $[p_2 \tau D+[(p_1+1)(v_0+1)]_\tau 1R]_M \tau+p_1$ |

FIG. 8

FIG. 9

FIG. 10

FIG. 11

FIG. 12

FIG. 13

1:Turbo Encoder

2:Input Data

41:Convolutional Encoder

42A:Convolutional Encoder

42B:Convolutional Encoder

3A:Interleaver

3B:Interleaver

410:Parity Stream

420A:Parity Stream

420B:Parity Stream

30A:Swapped Data

30B:Swapped Data

## INTERNATIONAL SEARCH REPORT

| International application No. |
| --- |
| **PCT/JP2023/040327** |

| A. | CLASSIFICATION OF SUBJECT MATTER |
| --- | --- |

*H03M 13/29*(2006.01)i; *H03M 13/27*(2006.01)i; *H04L 1/00*(2006.01)i
FI:    H03M13/29; H03M13/27; H04L1/00 F

According to International Patent Classification (IPC) or to both national classification and IPC

| B. | FIELDS SEARCHED |
| --- | --- |

Minimum documentation searched (classification system followed by classification symbols)

H03M13/29; H03M13/27; H04L1/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| X | JP 2002-541712 A (SAMSUNG ELECTRONICS CO., LTD.) 03 December 2002 (2002-12-03) | 1, 9-11, 14-15 |
|  | paragraphs [0001]-[0047], fig. 1, 4, 6-7 | |
| Y |  | 13 |
| A |  | 2-8, 12 |
| X | 山口 和彦, インタリーブを有する畳込み符号の重み分布に関する一考察, 電子情報通信学会技術研究報告, 1997, vol. 97, no. 80, pp. 37-41, (YAMAGUCHI, Kazuhiko. A Study on weight distributions of Convolutional Codes with Interleaver. IEICE Technical Report.) sections 2-4 | 1, 9-11, 15 |
| Y |  | 13 |
| X | JP 2000-156646 A (CANON INC) 06 June 2000 (2000-06-06) | 1, 9-11, 15 |
|  | paragraphs [0012]-[0044], [0052], [0087]-[0105], [0149]-[0155], [0174]-[0187], fig. 1, 2 | |
| Y |  | 13 |

☑ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **15 January 2024** | **23 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
|---|
| **PCT/JP2023/040327** |

| C. | DOCUMENTS CONSIDERED TO BE RELEVANT | | |
|---|---|---|
| Category* | Citation of document, with indication, where appropriate, of the relevant passages | Relevant to claim No. |
| Y | 松平 英　他, マルティプルターボ符号における決定性インタリーバの有効性について, 第３０回情報理論とその応用シンポジウム予稿集, 2007, pp. 214-219, (The proceedings of the 30th Symposium on Information Theory and Its Applications), non-official translation (MATSUDAIRA, Akira. Regarding effectiveness of deterministic interleavers in multiple turbo codes.)<br>　　　fig. 1 | 13 |

Form PCT/ISA/210 (second sheet) (July 2022)

**INTERNATIONAL SEARCH REPORT**
Information on patent family members

International application No.

**PCT/JP2023/040327**

| Patent document cited in search report | | | Publication date (day/month/year) | Patent family member(s) | | | Publication date (day/month/year) |
|---|---|---|---|---|---|---|---|
| JP | 2002-541712 | A | 03 December 2002 | US | 6591381 | B1 | |
| | | | | column 1, line 5 to column 9, line 6, fig. 1, 4, 6-7 | | | |
| | | | | WO | 2000/060752 | A1 | |
| | | | | KR | 10-2000-0071582 | A | |
| | | | | CN | 1345485 | A | |
| JP | 2000-156646 | A | 06 June 2000 | EP | 1001544 | A1 | |
| | | | | paragraphs [0013]-[0040], [0048], [0093]-[0109], [0142]-[0146], [0163]-[0169], fig. 1, 2 | | | |
| | | | | US | 6766489 | B1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022182371 A